(19)

Europäisches
Patentamt
European
Patent Office
Office européen
des brevets

(11) **EP 2 278 050 A1**

(12) **EUROPEAN PATENT APPLICATION**

(43) Date of publication:
  **26.01.2011 Bulletin 2011/04**

(51) Int Cl.:
  ***C30B 11/00*** (2006.01)   ***C30B 29/20*** (2006.01)

(21) Application number: **10251237.3**

(22) Date of filing: **09.07.2010**

(84) Designated Contracting States:
  **AL AT BE BG CH CY CZ DE DK EE ES FI FR GB
  GR HR HU IE IS IT LI LT LU LV MC MK MT NL NO
  PL PT RO SE SI SK SM TR**
  Designated Extension States:
  **BA ME RS**

(30) Priority: **22.07.2009 JP 2009171256**

(71) Applicants:
  • **Shinshu University
    Matsumoto-shi, Nagano 390-8621 (JP)**
  • **Fujikoshi Machinery Corp.
    Nagano-shi
    Nagano 381-1233 (JP)**

(72) Inventors:
  • **Hoshikawa, Keigo
    Nagano-shi
    Nagano 381-1233 (JP)**
  • **Miyagawa, Chihiro
    Nagano-shi
    Nagano 381-1233 (JP)**
  • **Nakamura, Taichi
    Nagano-shi
    Nagano 381-1233 (JP)**

(74) Representative: **Calderbank, Thomas Roger et al
  Mewburn Ellis LLP
  33 Gutter Lane
  London
  EC2V 8AS (GB)**

(54) **Method and equipment for producing sapphire single crystal**

(57)   The method can produce a sapphire single crystal without forming cracks and without using an expensive crucible. The method comprises: putting a seed crystal (24) and a raw material (26) in a crucible (20); heating the crucible (20) by a cylindrical heater (14); and producing temperature gradient in the cylindrical heater (14) to sequentially crystallize a melt. The crucible (20) is composed of a material having a specific linear expansion coefficient which is capable of preventing mutual stress, which is caused by a difference between a linear expansion coefficient of the crucible (20) and that of the sapphire single crystal in a direction perpendicular to a growth axis, from generating in the crucible (20) and the sapphire single crystal, or which is capable of preventing deformation of the crucible (20) without generating a crystal defect caused by the mutual stress.

FIG.1

EP 2 278 050 A1

**Description**

The present invention relates to a method and equipment for producing a sapphire single crystal.

Sapphire has been used for a number of things. These days, it is important to use sapphire substrates for producing LEDs. In this field, an LED substrate is produced mainly by epitaxially-growing a buffer layer and a gallium nitride film on a sapphire substrate.

Therefore, a method for producing a sapphire single crystal which is capable of efficiently and stably producing sapphire has been required.

Most of sapphire substrates used for producing LEDs are substrates of c-plane (0001). Conventionally, in the industrial field, sapphire single crystals are produced by the edge-defined film-fed growth (EFG) method, the Kyropoulos (KP) method, the Czochralski (CZ) method, etc.. In case of producing a single crystal whose diameter is three inches or more, various crystal defects will generate therein, so a single crystal grown in a-axis has been alternately used. To form c-axis sapphire crystal boule by processing the a-axis sapphire crystal, the a-axis sapphire crystal must be hollowed from a side. Therefore, the above described conventional technology has following disadvantages: processing the crystal is difficult; large disuse parts must be left; and material yield must be lowered.

The vertical Bridgeman method (vertical gradient freeze method) has been known as a method for producing an oxide single crystal. In the vertical Bridgeman method, a thin-walled crucible is used so as to easily take out a produced crystal therefrom. However, a sapphire single crystal is formed from a high temperature melt, so a material of the thin-walled crucible, which has high strength and high chemical resistance under high temperature, has been required. Japanese Laid-open Patent Publication P2007-119297A discloses a material having high strength and high chemical resistance under high temperature. In the Japanese patent publication, a crucible is composed of iridium, and the crucible composed of iridium has high strength and high chemical resistance under high temperature.

However, the conventional technology disclosed in the Japanese patent publication has following disadvantages: the crucible is composed of iridium, but iridium is very expensive; and a linear expansion coefficient of iridium is great, so the crucible is shrunk while a crystallizing process, stress is applied to crystals and cracks will form in the sapphire crystals.

Accordingly, it is a preferred aim in one aspect of the invention to provide a method and equipment for producing a sapphire single crystal, which are capable of producing a sapphire single crystal without forming cracks and without using an expensive crucible.

The method of the present invention may comprise the steps of:

putting a seed crystal and a raw material in a crucible;
setting the crucible in a cylindrical heater located in a growth furnace;
heating the crucible so as to melt all of the raw material and a part of the seed crystal; and

producing temperature gradient in the cylindrical heater, in which temperature of an upper part is higher than that of a lower part, so as to perform the directional solidification method for sequentially crystallizing the melt, and
the method is **characterized in that** the crucible is composed of a material having a specific linear expansion coefficient which is capable of preventing mutual stress, which is caused by a difference between a linear expansion coefficient of the crucible and that of the sapphire single crystal to be produced in a direction perpendicular to a growth axis thereof, from generating in the crucible and the sapphire single crystal, or which is capable of preventing deformation of the crucible caused by the mutual stress without generating a crystal defect caused by the mutual stress in the sapphire single crystal.

Next, the equipment of the present invention performing the steps of: putting a seed crystal and a raw material in a crucible; setting the crucible in a cylindrical heater located in a growth furnace; heating the crucible so as to melt all of the raw material and a part of the seed crystal; and producing temperature gradient in the cylindrical heater, in which temperature of an upper part is higher than that of a lower part, so as to perform the directional solidification method for sequentially crystallizing the melt, and
the equipment is **characterized in that** the crucible is composed of a material having a specific linear expansion coefficient which is capable of preventing mutual stress, which is caused by a difference between a linear expansion coefficient of the crucible and that of the sapphire single crystal to be produced in a direction perpendicular to a growth axis thereof, from generating in the crucible and the sapphire single crystal, or which is capable of preventing deformation of the crucible caused by the mutual stress without generating a crystal defect caused by the mutual stress in the sapphire single crystal.

In the method and equipment, the crucible may be composed of a material whose linear expansion coefficient between the melting temperature of sapphire and the room temperature is smaller than that of the sapphire single crystal to be produced, in the direction perpendicular to the growth axis, between the melting temperature of sapphire and the room temperature.

In the method and equipment, the crucible may be composed of a material whose linear expansion coefficient , between the melting temperature of sapphire and each of optional temperatures equal to or higher than the room temperature, is always smaller than that of the sapphire single crystal to be produced, in the direction perpendicular to the growth axis, from the melting temperature of sapphire to the room temperature.

For example, the crucible may be composed of tungsten, molybdenum or an alloy of tungsten and molybdenum.

Further, the method may further comprise the steps of:

cooling the inner space of the cylindrical heater, in the same growth furnace, until reaching prescribed temperature by reducing heating power of the cylindrical heater after crystallizing the melt; and
placing the crucible in a soak zone of the cylindrical heater, which is a mid part thereof, for a predetermined time period so as to anneal the sapphire single crystal in the crucible.

In the method and equipment, even if the growth axis of the sapphire single crystal is c-axis, the sapphire single crystal can be grown without forming crystal defects, e.g., cracks.

In the present invention, the crucible is composed of the material having the specific linear expansion coefficient, so that applying stress, which is caused by shrinkage of the crucible, to the grown single crystal can be prevented while performing the steps of crystallizing the melt and cooling the single crystal. Therefore, generating crystal defects, e.g., cracks, in the sapphire crystal can be prevented, and a high quality sapphire single crystal, which has few crystal defects, can be produced. Further, the deformation of the crucible can be prevented and no stress is applied to the crystal and an inner wall face of the crucible when the crystal is taken out, so that the crystal can be easily taken out and the crucible can be repeatedly used.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

Embodiments of the present invention will now be described by way of examples and with reference to the accompanying drawings, in which:

Fig. 1 is a sectional view of an equipment for producing a sapphire single crystal;
Fig. 2 is a graph showing linear expansion coefficients of tungsten, molybdenum, sapphire in the direction perpendicular to the c-axis and sapphire in the direction of the c-axis;
Figs. 3A-3F are explanation views showing the steps of crystallizing sapphire and annealing the sapphire single crystal;
Figs. 4A and 4B are explanation views of a cooled crucible, in which gaps are formed between an inner wall face of a crucible and an outer face of a sapphire single crystal;
Fig. 5 is a photograph of a sapphire single crystal produced in EXAMPLE 1; and
Fig. 6 is a photograph of a sapphire single crystal produced in EXAMPLE 2.

Preferred embodiments of the present invention will now be described in detail with reference to the accompanying drawings.

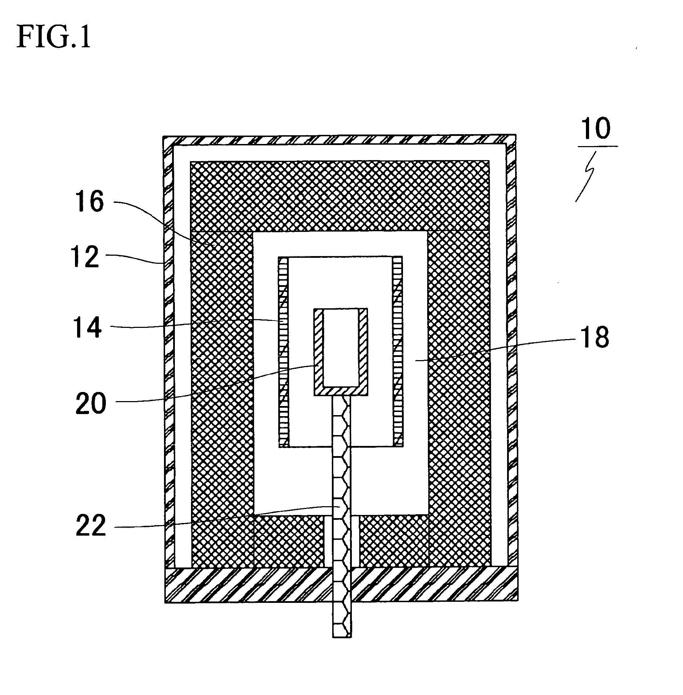

Fig. 1 is a sectional view of an equipment (growth furnace) 10 for producing a sapphire single crystal.

The equipment 10 is a known vertical Bridgeman furnace. The structure of the furnace will be briefly explained. An inner space of the equipment (growth furnace) 10 is enclosed by a cylindrical jacket 12, through which cooling water runs, and at least one cylindrical heater 14, which is vertically arranged, is provided in the inner space of the furnace. Note that, in the present embodiment, one cylindrical heater 14 is used.

In the present embodiment, the cylindrical heater 14 is a carbon heater. A control section (not shown) controls electric power distribution to the cylindrical heater 14 so as to adjust temperature of the cylindrical heater 14.

An insulating member 16 encloses the cylindrical heater 14 and forms a chamber 18.

By controlling the electric power distribution to the cylindrical heater 14, temperature gradient can be vertically produced in the chamber 18.

An upper end of a shaft 22 is connected to a bottom part of a crucible 20. By vertically moving the shaft 22, the crucible 20 is vertically moved in the cylindrical heater 14. By rotating the shaft 22 about its axial line, the crucible 20 is rotated.

The shaft 22 is vertically moved by a ball screw (not shown), so that a speed of vertically moving the crucible 20 can be precisely controlled.

The growth furnace 10 has two opening sections (not shown) so as to supply and discharge an inert gas, preferably an argon gas. The growth furnace 10 is filled with the inert gas while growing a crystal.

Note that, thermometers (not shown) are provided at a plurality of positions in the growth furnace 10.

The crucible 20 is composed of a material having a specific linear expansion coefficient which is capable of preventing mutual stress, which is caused by a difference between a linear expansion coefficient of the crucible and a linear expansion coefficient of the sapphire single crystal to be produced in a direction perpendicular to a growth axis of the sapphire single crystal, from generating in the crucible 20 and the grown sapphire single crystal, or which is capable of preventing deformation of the crucible 20 caused by the mutual stress without generating a crystal defect or defects caused by the mutual stress in the grown sapphire single crystal.

Preferably, the crucible 20 is composed of a material whose linear expansion coefficient between the melting temperature of sapphire (2050°C) and the room temperature is smaller than that of the sapphire single crystal to be produced, in the direction perpendicular to the growth axis, between the melting temperature of sapphire (2050°C) and the room temperature.

The linear expansion coefficient ($\alpha$) between the melting temperature of sapphire and the room temperature is calculated by the following formula:

$$\alpha = (L_1 - L_0) / L_0 (T_1 - T_0)$$

wherein $L_0$ is a length at the melting temperature of sapphire, $L_1$ is a length at the room temperature, $T_0$ is the melting temperature of sapphire, and $T_1$ is the room temperature.

More preferably, the crucible 20 is composed of a material whose linear expansion coefficient, between the melting temperature of sapphire (2050°C) and each of optional temperatures equal to or higher than the room temperature, is always smaller than that of the sapphire single crystal to be produced, in the direction perpendicular to the growth axis, while cooling the crystal from the melting temperature of sapphire (2050°C) to the room temperature.

The linear expansion coefficient ($\alpha$) between the melting temperature of sapphire and each of optional temperatures, which is equal to or higher than the room temperature, is calculated by the following formula:

$$\alpha = (L_x - L_0) / L_0 (T_x - T_0)$$

wherein $L_0$ is a length at the melting temperature of sapphire, $L_x$ is a length at the optional temperature, $T_0$ is the melting temperature of sapphire, and $T_x$ is the optional temperature.

Note that, the linear expansion coefficient ($\alpha$) may be measured data or existing data.

The material of the crucible 20 may be, for example, tungsten, molybdenum, or an alloy of tungsten and molybdenum.

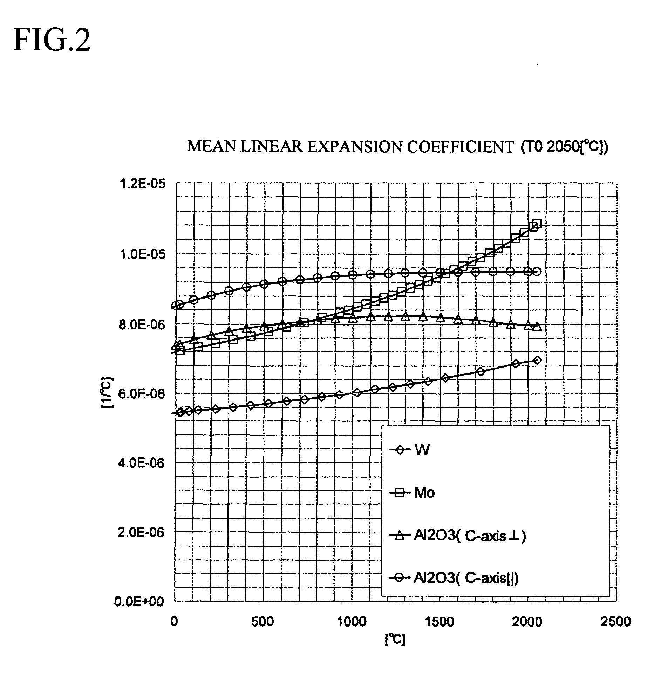

Fig. 2 is a graph showing linear expansion coefficients, between the melting temperature of sapphire and each of optional temperatures equal to or higher than the room temperature, of tungsten, molybdenum, sapphire in the direction perpendicular to the c-axis and that of sapphire in the direction of the c-axis.

Especially, as clearly shown the graph, the linear expansion coefficient of tungsten is smaller than that of sapphire at each temperature. In each of the crucibles 20 composed of the above described materials, a rate of shrinkage of the crucible 20 is smaller than that of sapphire while performing a crystallizing step, an annealing step and a cooling step, so that an inner wall face of the crucible 20 is separated from an outer face of a produced sapphire single crystal, no stress is applied to the produced sapphire single crystal and forming cracks in the crystal can be prevented.

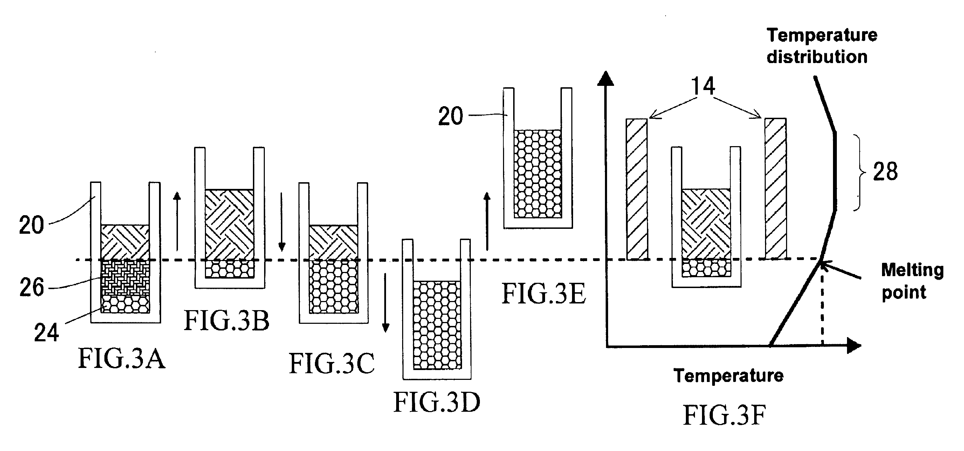

Next, the crystallizing step and the annealing step will be explained with reference to Figs. 3A-3F.

In Fig. 3A, a sapphire seed crystal 24 and a raw material 26 are put in the crucible 20.

Temperature of a hot zone of the growth furnace 10 enclosed by the cylindrical heater 14 is controlled. Namely, as shown in Fig. 3F, temperature of an upper part of the hot zone is higher than the melting temperature of sapphire; temperature of a lower part thereof is lower than the melting temperature of sapphire.

The crucible 20, in which the sapphire seed crystal 24 and the raw material 26 have been accommodated, are moved from the lower part of the hot zone to the upper part thereof. When the raw material 26 and an upper part of the sapphire seed crystal 24 are melted, the upward movement of the crucible 20 is stopped (see Fig. 3B). Next, the crucible 20 is moved downward at a predetermined slow speed (see Fig. 3C). With these actions, the melt of the raw material 26 and the sapphire seed crystal 24 is gradually crystallized and deposits along a crystal plane of the remaining sapphire seed crystal 24 (see Figs. 3C and 3D).

The sapphire seed crystal 24 is set in the crucible 20, and c-plane of the sapphire seed crystal 24 is horizontalized. The melt is grown along the c-plane, i.e., in the direction of c-axis.

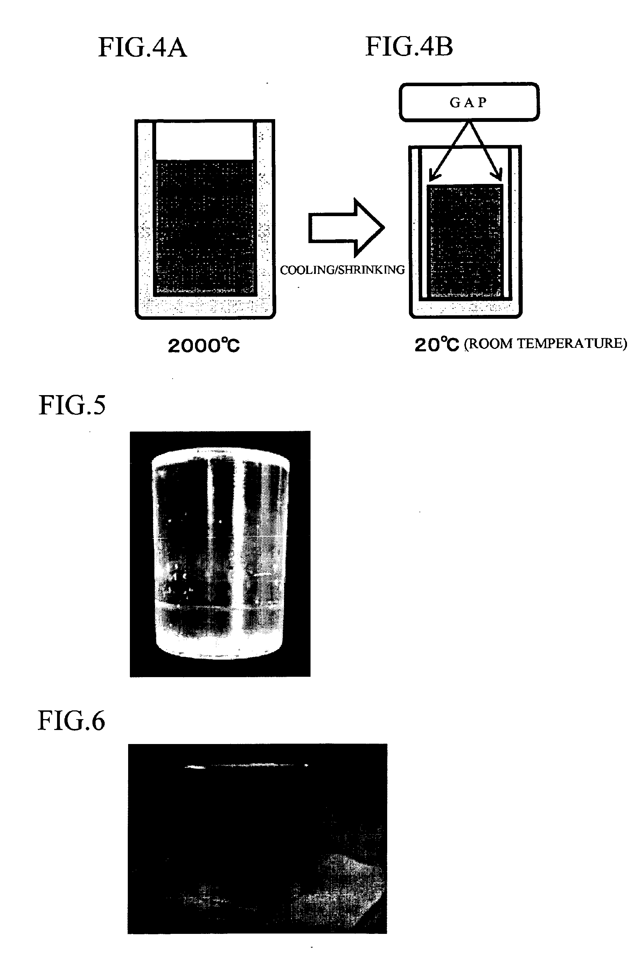

Since crucible 20 is composed of the above described material, e.g., tungsten, the inner wall face of the crucible 20 is separated from the outer face of the produced sapphire single crystal while performing the crystallizing step, the annealing step and the cooling step, as shown in Fig. 4B. Therefore, no external stress is applied to the produced sapphire crystal and formin cracks therein can be prevented. Further, no stress is applied to the inner wall face of the crucible 20 and the produced crystal, so that the produced crystal can be easily taken out from the crucible 20 and the crucible 20 can be repeatedly used without being deformed.

In the present embodiment, the inner space of the cylindrical heater 14 is cooled, in the same growth furnace 10, until reaching prescribed temperature, e.g., 1800°C, by reducing heating power of the cylindrical heater 14 after crystallizing the melt, and the crucible 20 is upwardly moved until reaching a soak zone 28 (see Fig. 3F) of the cylindrical heater 14, which is a mid part thereof and in which temperature gradient is lower than other parts (see Fig. 3E). The crucible 20 is placed in the soak zone 28 for a predetermined time period, e.g., one hour, so as to anneal the sapphire single crystal in the crucible 20.

By annealing the sapphire single crystal on the crucible 20 in the same growth furnace 10, the annealing step can be efficiently performed, thermal stress in the produced crystal can be eliminated. Therefore, the high quality sapphire single crystal, which has few crystal defects, can be produced. Since the produced crystal on the crucible 20 can be crystallized and annealed in the same growth furnace 10, desired crystals can be efficiently produced and energy consumption can be lowered. Note that, the above described annealing treatment effectively removes residual stress of the produced crystal. In case that the produced crystal is less stressed, the annealing treatment may be omitted.

In the above described embodiment, the vertical Bridgeman method (directional solidification method) is performed. Further, single sapphire crystals may be crystallized and annealed by other directional solidification methods, e.g., vertical gradient freezing (VGF) method. In the vertical gradient freeze method too, a crucible is upwardly moved, in a cylindrical heater, until reaching a soak zone to perform the annealing step.

In the above described embodiment, the growth axis of the crystal is the c-axis. Further, a-axis or a direction perpendicular to R-plane may be the growth axis.

(EXAMPLE 1)

A sapphire single crystal (a diameter of an upper face was 77.5 mm; a taper angle was 2°; a thickness was 30 mm; and a weight was 539.4 g.) was putted in a crucible composed of tungsten as a seed crystal. An offcut of sapphire single crystal (weight was 1664.1 g.) was putted on the seed crystal as a raw material. The seed crystal was designed to form a gap of 0.3 mm between an outer face of the seed crystal and an inner wall face of the crucible. The prescribed gap was formed between the seed crystal and the inner wall face of the crucible so as to prevent tight contact between the expanding seed crystal and the inner wall face of the crucible.

An inner bottom part of the crucible had a diameter of 76 mm, and the inner wall face thereof was a female taper face whose taper angle was 2°and whose inner diameter was gradually increased upward.

The crucible was set in a cylindrical electric furnace, which has a hot zone of 2050°C or more, so as to produce a sapphire single crystal.

When the temperature of the electric furnace was increased and constant heating power was obtained, the crucible was upwardly moved 55 mm, at a speed of 2-10 mm/h, so as to melt a part of the seed crystal, i.e., half the height of the seed crystal.

From there, the crucible was downwardly moved 120 mm, at a speed of 2-5 mm/h, so as to grow a sapphire single crystal. In this process, temperature gradient was 7°C/cm.

Then, the heating power of the electric furnace was reduced so as to cool the single crystal. Simultaneously, the crucible was upwardly moved 140 mm, at a speed of 20-23 mm/h, so as to move the crucible to a soak zone, which was a mid part of the cylindrical furnace and in which temperature gradient was 5-2°C/cm, so that the grown single crystal was annealed and residual stress was removed. In the annealing treatment, temperature of the single crystal was reduced to and maintained at 1800°C for one hour, and then the heating power was reduced to cool the grown single crystal without changing the height of the crucible.

A gap was formed between an inner wall face of the crucible and the sapphire single crystal to be taken out, so that the sapphire single crystal could be easily taken out from the crucible. The produced sapphire single crystal was grown, without cracks, as a single crystal and had a length of 115 mm (see Fig. 5). A weight of the produced sapphire single crystal was 2203. 5 g, and the weight was equal to a total weight of the seed crystal and the raw material putted in the crucible.

An outer diameter of the crucible was measured after producing the sapphire single crystal. The measured diameter was equal to that of the crucible before producing the sapphire single crystal. Surface condition of an inner face of the crucible was not changed.

The produced sapphire single crystal was sliced to form into wafers, and both side faces of each of the wafers were lapped. The process could be suitable performed without forming cracks.

(EXAMPLE 2)

A c-axis sapphire single crystal (a diameter of an upper face was 77 mm; a taper angle was 2°; a thickness was 50 mm; and a weight was 940 g.) was putted in a crucible composed of molybdenum as a seed crystal. An offcut of sapphire single crystal (weight was 150 g.) was putted on the seed crystal as a raw material. The seed crystal was designed to form a gap of 0.5 mm between an outer face of the seed crystal and an inner wall face of the crucible.

An inner bottom part of the crucible had a diameter of 76 mm, and the inner wall face thereof was a female taper face whose taper angle was 1.2° and whose inner diameter was gradually increased upward.

The crucible was set in a cylindrical electric furnace, which has a hot zone of 2050°C or more, so as to produce a sapphire single crystal.

When the temperature of the electric furnace was increased and constant heating power was obtained, the crucible was upwardly moved 60 mm, at a speed of 5-20 mm/h, so as to melt a part of the seed crystal, i.e., about 35 mm from a lower face of the seed crystal.

From there, the crucible was downwardly moved 60 mm, at a speed of 2 mm/h, so as to grow a sapphire single crystal. In this process, temperature gradient was 7°C/cm.

Then, the heating power of the electric furnace was reduced so as to cool the single crystal. Simultaneously, the crucible was upwardly moved 150 mm, at a speed of 22 mm/h, so as to move the crucible to a soak zone, which is a mid part of the cylindrical furnace and in which temperature gradient was 5-2°C/cm, so that the grown single crystal was annealed and residual strain was removed. In the annealing treatment, temperature of the single crystal was reduced to and maintained at 1800°C for 3.5 hours, and then the heating power was reduced to cool the grown single crystal without changing the height of the crucible.

A gap was formed between an inner wall face of the crucible and the sapphire single crystal to be taken out, so that the sapphire single crystal could be easily taken out from the crucible. The produced sapphire single crystal was grown as a single crystal and had a length of 62 mm, but a crack of 20 mm was formed in an outer circumferential face (see Fig. 6). A weight of the produced sapphire single crystal was 1090 g, and the weight was equal to a total weight of the seed crystal and the raw material putted in the crucible.

Preferably, the crucible used in the present invention has been previously heat-treated so as to prevent deformation.

Two examples relating to the present invention have been explained above. A linear expansion coefficient of a tungsten material of the crucible was slightly varied according to a type of tungsten material or a manner of producing the crucible, but the linear expansion coefficient of the tungsten material is smaller than that of the sapphire single crystal, between 2050°C and each of optional temperatures equal to or higher than the room temperature, while cooling the sapphire single crystal from 2050°C to the room temperature. At present, it is thought that tungsten is the most preferable material of the crucible.

On the other hand, a linear expansion coefficient of a molybdenum material of the crucible between 2050°C and the room temperature was smaller than a linear expansion coefficient of the sapphire single crystal therebetween. Therefore, the produced sapphire single crystal could be easily taken out from the crucible. However, the linear expansion coefficient, between 2050°C and each of optional temperatures equal to or higher than the room temperature, of the molybdenum crucible was greater than that of the sapphire single crystal in a specified temperature range, so compressive stress was generated between the crucible and the sapphire single crystal while cooling the produced crystal. Therefore, it is thought that the crack of 20 mm was formed in the outer circumferential face of the sapphire single crystal as described in Example 2. Generally, the linear expansion coefficient of molybdenum is greater than that of tungsten, so molybdenum is not the most preferable material of the crucible, but some molybdenum materials realize the method and equipment of the present invention.

Further, an alloy of tungsten and molybdenum may be used as the material of the crucible.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention has been described in detail, it should be understood that the various changes, substitutions, and alternations could be made hereto without departing from the spirit and scope of the invention.

**Claims**

1. A method for producing a sapphire single crystal comprising the steps of: putting a seed crystal (24) and a raw material (26) in a crucible (20); setting the crucible (20) in a cylindrical heater (14) located in a growth furnace (10); heating the crucible (20) so as to melt all of the raw material (26) and a part of the seed crystal (24); and producing temperature gradient in the cylindrical heater (14), in which temperature of an upper part is higher than that of a lower part, so as to perform the directional solidification method for sequentially crystallizing the melt,
the method being **characterized in that** the crucible (20) is composed of a material having a specific linear expansion coefficient which is capable of preventing mutual stress, which is caused by a difference between a linear expansion coefficient of the crucible (20) and that of the sapphire single crystal to be produced in a direction perpendicular to a growth axis thereof, from generating in the crucible (20) and the sapphire single crystal, or which is capable of preventing deformation of the crucible (20) caused by the mutual stress without generating a crystal defect caused by the mutual stress in the sapphire single crystal.

2. The method according to claim 1,
wherein the crucible (20) is composed of a material whose linear expansion coefficient between the melting temperature of sapphire and the room temperature is smaller than that of the sapphire single crystal to be produced, in the direction perpendicular to the growth axis, between the melting temperature of sapphire and the room temperature.

3. The method according to claim 1,
wherein the crucible (20) is composed of a material whose linear expansion coefficient, between the melting temperature of sapphire and each of optional temperatures equal to or higher than the room temperature, is always smaller than that of the sapphire single crystal to be produced, in the direction perpendicular to the growth axis, from the melting temperature of sapphire to the room temperature.

4. The method according to one of claims 1-3,
further comprising the steps of:

cooling the inner space of the cylindrical heater (14), in the same growth furnace (10), until reaching prescribed temperature by reducing heating power of the cylindrical heater (14) after crystallizing the melt; and
placing the crucible (20) in a soak zone (28) of the cylindrical heater (14), which is a mid part thereof, for a predetermined time period so as to anneal the sapphire single crystal in the crucible (20).

5. The method according to one of claims 1-4,
wherein the crucible (20) is composed of tungsten.

6. The method according to one of claims 1-4,
wherein the crucible (20) is composed of an alloy of tungsten and molybdenum.

7. The method according to claim 2 or 4,
wherein the crucible (20) is composed of molybdenum.

8. The method according to one of claims 1-7,
wherein the growth axis of the sapphire single crystal is c-axis.

9. An equipment for producing a sapphire single crystal, the equipment performing the steps of: putting a seed crystal (24) and a raw material (26) in a crucible (20); setting the crucible (20) in a cylindrical heater (14) located in a growth furnace (10); heating the crucible (20) so as to melt all of the raw material (26) and a part of the seed crystal (24); and producing temperature gradient in the cylindrical heater (14), in which temperature of an upper part is higher than that of a lower part, so as to perform the directional solidification method for sequentially crystallizing the melt, the equipment being **characterized in that** the crucible (20) is composed of a material having a specific linear expansion coefficient which is capable of preventing mutual stress, which is caused by a difference between a linear expansion coefficient of the crucible (20) and that of the sapphire single crystal to be produced in a direction perpendicular to a growth axis thereof, from generating in the crucible (20) and the sapphire single crystal, or which is capable of preventing deformation of the crucible (20) caused by the mutual stress without generating a crystal defect caused by the mutual stress in the sapphire single crystal.

10. The equipment according to claim 9,
wherein the crucible (20) is composed of a material whose linear expansion coefficient between the melting temperature of sapphire and the room temperature is smaller than that of the sapphire single crystal to be produced, in the direction perpendicular to the growth axis, between the melting temperature of sapphire and the room temperature.

**11.** The equipment according to claim 9,
wherein the crucible (20) is composed of a material whose linear expansion coefficient, between the melting temperature of sapphire and each of optional temperatures equal to or higher than the room temperature, is always smaller than that of the sapphire single crystal to be produced, in the direction perpendicular to the growth axis, from the melting temperature of sapphire to the room temperature.

**12.** The equipment according to one of claims 9-11,
wherein the crucible (20) is composed of tungsten.

**13.** The equipment according to one of claims 9-11,
wherein the crucible (20) is composed of an alloy of tungsten and molybdenum.

**14.** The equipment according to one of claims 9-11,
wherein the crucible (20) is composed of molybdenum.

FIG.1

# FIG.2

MEAN LINEAR EXPANSION COEFFICIENT (TO 2050[°C])

FIG.3A
FIG.3B
FIG.3C
FIG.3D
FIG.3E
FIG.3F

FIG.4A                    FIG.4B

2000°C            20°C (ROOM TEMPERATURE)

FIG.5

FIG.6

**EP 2 278 050 A1**

Europäisches
Patentamt

European
Patent Office

Office européen
des brevets

# EUROPEAN SEARCH REPORT

Application Number

EP 10 25 1237

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 608 050 A (CARMAN JUSTICE N ET AL) 21 September 1971 (1971-09-21) * column 5, line 44 - column 7, line 15 * * figures 2, 5 * * claim 1 * ----- | 1-5, 7-12,14 | INV. C30B11/00 C30B29/20 |
| X | US 4 186 046 A (DELAI A JOSEPH [US] ET AL) 29 January 1980 (1980-01-29) * column 2, line 36 - column 3, line 23 * * claim 1 * ----- | 1-3,5, 7-12,14 | |

TECHNICAL FIELDS
SEARCHED (IPC)

C30B

The present search report has been drawn up for all claims

| Place of search | Date of completion of the search | Examiner |
|---|---|---|
| The Hague | 20 September 2010 | Straub, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

13

## ANNEX TO THE EUROPEAN SEARCH REPORT
## ON EUROPEAN PATENT APPLICATION NO.

EP 10 25 1237

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2010

| Patent document cited in search report | | Publication date | Patent family member(s) | | Publication date |
|---|---|---|---|---|---|
| US 3608050 | A | 21-09-1971 | CH | 576280 A5 | 15-06-1976 |
| | | | DE | 2038690 A1 | 18-03-1971 |
| | | | FR | 2057869 A6 | 21-05-1971 |
| US 4186046 | A | 29-01-1980 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP P2007119297 A